# EUROPÄISCHE PATENTSCHRIFT

(11) **EP 2 799 766 B1**
(45) Veröffentlichungstag und Bekanntmachung des Hinweises auf die Patenterteilung: **19.10.2016**
(21) Anmeldenummer: 14166402.9
(22) Anmeldetag: 29.04.2014
(51) Int. Cl.: F21V 19/00, F21V 23/00, F21V 23/04, F21Y 115/10

(54) **LED Modul mit Konverter-Schaltung**
LED module with converter circuit
Module à DEL dotée d'une commutation de convertisseur

(30) Priorität: 30.04.2013 DE 102013207965; 24.10.2013 DE 102013221647
(43) Veröffentlichungstag der Anmeldung: 05.11.2014
(73) Patentinhaber: Tridonic Jennersdorf GmbH, 8380 Jennersdorf (AT)
(72) Erfinder: Gumhold, Jürgen, 8380 Jennersdorf (AT); Wimmer, Florian, 8380 Jennersdorf (AT)
(74) Vertreter: Rupp, Christian

(56) Entgegenhaltungen:
- EP-A1- 2 474 781
- EP-A2- 2 333 405
- EP-A2- 2 339 230
- WO-A1-2012/056761
- WO-A2-2011/141846
- US-A1- 2008 123 341
- US-A1- 2011 193 484

## Beschreibung

Die vorliegende Anmeldung bezieht sich auf ein LED Modul mit modularem Aufbau, wobei die einzelnen Komponenten des Moduls selektiv miteinander verbindbar sind.

LED Leuchten oder LED Module, welche mehrere LEDs aufweisen sind im Stand der Technik bekannt. Dabei sind im Allgemeinen eine Vielzahl von einzelnen LED Chips auf einer gemeinsamen Leiterplatte oder Platine montiert, welche wiederum in der Leuchte verbaut ist.

Die US 2011/0193484 A1 und EP 2 339 230 A2 beschreiben LED Module des Stands der Technik.

Ein Problem ergibt sich dabei hinsichtlich der Austauschbarkeit einzelner Komponenten derartiger Leuchten. Insbesondere wenn beispielsweise einer der auf die Leiterplatte montierten LED Chips auszutauschen ist, muss häufig die gesamte Leuchte ersetzt werden, da die LED Chips nicht oder nur mit großen Aufwand von der gemeinsamen Leiterplatte trennbar bzw. austauschbar sind. Eine Aufgabe der Erfindung ist es daher, ein LED Modul mit modularem Aufbau bereitzustellen, welches eine vereinfachte Austauschbarkeit der einzelnen Komponenten ermöglicht.

Des Weiteren liegt der vorliegenden Erfindung die Aufgabe zugrunde ein integrales LED Modul bereitzustellen, welches neben einer vereinfachten Austauschbarkeit des oder der LED Chips eine vereinfachte Verbauung in einer Lampenkonstruktion ermöglicht.

Diese Aufgaben werden durch den Gegenstand des unabhängigen Anspruchs gelöst. Vorteilhafte

Ausgestaltungen und Weiterbildungen der Erfindung ergeben sich aus den Unteransprüchen.

Die Erfindung bezieht sich auf ein LED Modul aufweisend eine Leiterplatte und ein LED Trägermodul, wobei die Leiterplatte eine integrierte Konverter-Elektronik für das LED Trägermodul aufweist, welche eingangsseitig der Konverter-Elektronik einen Anschluss der Leiterplatte an Netzspannung ermöglicht, wobei das LED Trägermodul wenigstens einen auf einem Substrat angeordneten LED Chip aufweist, und wobei das Trägermodul durch vorgesehene mechanische Verbindungsmittel selektiv mit der Leiterplatte verbindbar ist.

Das erfindungsgemäße LED Module ermöglicht den direkten Anschluss des LED Modules an die Netzspannungsversorgung. Es wird demnach ein integrales LED Modul bereitgestellt, welches direkt in einer vorgesehenen Lampe verbaut werden kann, wobei keine zusätzliche Steuerungselektronik oder Konverter-Komponenten in der Lampe vorgesehen werden müssen. Stattdessen kann das LED Modul direkt an eine Netzspannungsversorgung angeschlossen werden.

Ein weiterer Vorteil ist die vereinfachte Austauschbarkeit des LED Trägermoduls, welches im Schadensfall einfach und ohne technische Vorkenntnisse und ohne Werkzeug ausgetauscht werden kann. Des Weiteren können neue LEDs bzw. weiterentwickelte Trägermodule einfach auf die bestehende Leiterplatte angeordnet werden.

Die Konverter-Elektronik ist vorzugsweise direkt auf der Leiterplatte bzw. Leiterplatine angebracht.

Die Konverter-Elektronik umfasst vorzugsweise ein Wandlermodul und/oder ein Gleichrichtermodul. Die Konverter-Elektronik ist vorzugsweise zur Ansteuerung der damit in Verbindung stehenden LED Chips auf dem Trägermodul ausgeprägt.

Das LED Modul umfasst ein Gehäuse, welches selektiv mit der Leiterplatte durch vorgesehene Verbindungsmittel verbindbar ist, derart, dass die Konverter-Elektronik der Leiterplatte von Umwelteinflüssen geschützt ist. Hierzu sind vorzugsweise Reibzapfen an dem Gehäuse angebracht, welche in vorgesehene Öffnungen bzw. Aussparungen auf der Leiterplatte einpressbar sind. Das Gehäuse ist vorzugsweise aus Plastik und/oder Metall. Das Gehäuse kann Dichtungen aufweisen, welche Zwischenräume zwischen dem Gehäuse und der Leiterplatte in deren verbundenem Zustand abdichten.

Das LED Modul kann ferner einen Reflektor umfassen, welcher selektiv mit der Leiterplatte und/oder einem an der Leiterplatte befestigten Gehäuse durch vorgesehene mechanische Verbindungsmittel verbindbar ist. Der Reflektor ist vorzugsweise aus Plastik und/oder Metall, z.B. Aluminium und kann eine innere, hochreflektierende Schicht aufweisen.

Es können mehrere Reflektoren unterschiedlicher Form und/oder Größe bzw. mit unterschiedlichen optischen Eigenschaften vorgesehen sein, welche mit gleichartig angeordneten Verbindungsmitteln ausgestattet sind. Demzufolge wird ein System bereitgestellt, in welchem ein gewählter Reflektor selektiv mit der Leiterplatte und/oder dem Gehäuse des LED Moduls verbindbar ist. Zudem können unterschiedliche Reflektoren in Abhängigkeit der zu erzielenden Reflektorwirkung einfach und unkompliziert ausgetauscht werden.

Die mechanischen Verbindungsmittel zwischen der Leiterplatte, dem Gehäuse und/oder dem Reflektor umfassen vorzugsweise einen Bajonette-Verschluss, Schrauben und/oder Reibzapfen, welche in dafür vorgesehene Öffnungen einpressbar sind. Die Verbindungsmittel sind vorzugsweise selektiv lösbar. Alternativ können auch Stoffschlussverfahren wie beispielsweise Verklebung einzelner Komponenten des Systems zu deren Verbindung vorgesehen sein.

Die Leiterplatte des LED Moduls weist vorzugsweise eine Ausnehmung auf, in welche das LED Trägermodul einsetzbar ist, derart, dass eine Rückseite des LED Trägermoduls vorzugsweise bündig mit einer Rückseite der Leiterplatte angeordnet ist.

Die Leiterplatte kann zudem einen Kühlkörper umfassen, welcher an einer Unterseite der Leiterplatte angeordnet ist bzw. mit dieser verbindbar ist.

Wenn die Leiterplatte eine Ausnehmung aufweist, in welche das LED Trägermodul einsetzbar ist, ist der Kühlkörper vorzugsweise derart angeordnet, dass die Rückseite des LED Trägermoduls mit dem Kühlkörper in Kontakt steht.

Alternativ oder zusätzlich kann auch ein Kühlkörper vorgesehen sein, welcher zwischen Leiterplatte und LED Trägermodul angebracht wird.

Das LED Trägermodul umfasst vorzugsweise wenigstens einen Sensor, welcher ausgeprägt ist, mit der Konverter-Elektronik der Leiterplatte zu kommunizieren. Der Sensor kann dabei beispielsweise ein Lichtsensor bzw. Photosensor, Temperatursensor und/oder Farbsensor sein. Der Sensor kann auch einen Tageslichtsensor, Bewegungsmelder, Rauchmelder oder Infrarotsensor umfassen.

Die Konverter-Elektronik der Leiterplatte ist vorzugsweise derart ausgeprägt ist, um eine Ansteuerung des wenigstens einen LED Chips des mit der Leiterplatte verbundenen LED Trägermoduls in Abhängigkeit von Informationen zu ermöglichen, welche von dem wenigstens einen Sensor des LED Trägermoduls bereitgestellt werden.

In einem bevorzugten Ausführungsbeispiel ist der wenigstens eine Sensor ein Tageslichtsensor, wobei die Konverter-Elektronik ausgeprägt ist, die Ansteuerung des LED Trägermoduls hinsichtlich der Lichtstärke und/oder Farbe abhängig von der vom Tageslichtsensor bereitgestellten Information durchzuführen. Auf diese Weise kann beispielsweise eine Ansteuerung des LED Trägermoduls bzw. des darauf angeordneten LED Chips derart erfolgen, dass der LED Chip abhängig von einem erfassten Tageslicht gedimmt wird.

Die Kommunikation zwischen dem wenigstens einen Sensor des LED Trägermoduls und der Konverter-Elektronik der Leiterplatte kann eine drahtlose oder drahtgebundene Datenkommunikation sein.

Für eine drahtgebundene Kommunikation weist das LED Trägermodul vorzugsweise Leiter bzw. Anschlüsse auf, welche mit dafür vorgesehenen elektrischen Leitern auf der Leiterplatte verbindbar sind. Vorzugsweise erfolgt eine Verbindung zwischen dem wenigstens einen Sensor und der Leiterplatte automatisch bei Verbindung bzw. Einsetzen des LED Trägermoduls in die vorgesehenen mechanischen Verbindungsmittel der Leiterplatte.

Auch die elektrische Kontaktierung des LED Trägermoduls und insbesondere des wenigstens einen LED Chips des Trägermoduls zur Konverter-Elektronik der Leiterplatte erfolgt vorzugsweise automatisch bei Verbindung bzw. Einsetzen des LED Trägermoduls in die vorgesehenen mechanischen Verbindungsmittel der Leiterplatte.

Hierfür sind vorzugsweise konforme Leiter bzw. Anschlüsse an Leiterplatte und LED Trägermodul angeordnet, welche bei der mechanischen Verbindung von Trägermodul und Leiterplatte verbunden bzw. kontaktiert werden.

Derartige Leiter oder Anschlüsse können auch von den mechanischen Verbindungsmitteln umfasst sein.

Bei einer drahtlosen Kommunikation zwischen dem wenigstens einen Sensor des LED Trägermoduls und der Konverter-Elektronik der Leiterplatte ist vorzugsweise ein Empfänger und/oder Sender in den jeweiligen Bauteilen angeordnet um eine derartige Kommunikation zu ermöglichen.

Das LED Trägermodul kann ein vorgefertigtes Distanzbauteil als Fertigbauteil aufweisen, vorzugsweise einen Keramikring, welches den wenigstens einen LED Chip umgibt.

Das Distanzbauteil des LED Trägermoduls bzw. der Keramikring kann mit einer Glas- oder Plastikscheibe abgedeckt sein. Der Keramikring kann zusätzlich oder stattdessen mit Vergussmasse gefüllt sein.

Der Sensor in dem Distanzbauteil ist vorzugsweise derart angeordnet, dass das von dem wenigstens einen LED Chip des Trägermoduls emittierte Licht nicht direkt auf den Sensor fällt.

Der Sensor kann hierzu beispielsweise auf einer Stirnseite des Distanzbauteils angeordnet sein.

Es können aber auch wenigstens eine Kante, Vorsprung oder dergleichen am Distanzbauteil vorgesehen sein, welche eine direkte Beaufschlagung des Sensors durch das von dem LED Chip emittierte Licht verhindert.

Das Distanzbauteil umfasst vorzugsweise auch elektrische Kontaktierungen, wie beispielsweise Leiterbahnen, welche einen Anschluss des Sensors an das LED Trägermodul und damit auch an die Leiterplatte des LED Moduls ermöglichen. Es können beispielsweise Leitungen mittels Dickschichttechnologie aufgedruckt oder gesintert werden.

Die in dem Distanzbauteil bzw. Keramikring eingebrachte Vergussmasse kann Epoxydharz und/oder Silikonmaterial umfassen. Die Vergussmasse weist vorzugsweise Phosphorpartikel auf, welche eine Konversion des von dem LED Chip abgestrahlten Lichts wenigstens teilweise ermöglichen.

Die Vergussmasse kann mittels Dispensverfahren auf den wenigstens einen LED Chip und/oder in das Distanzbauteil gefüllt werden.

Die Vergussmasse kann auch Füllstoffe enthalten, welche die thermischen Eigenschaften der Vergussmasse verbessern. Der wenigstens eine LED Chip des LED Trägermoduls ist vorzugsweise eine UV- oder Blaulicht emittierender LED Chip.

Das LED Trägermodul ist vorzugsweise ausgeprägt um Mischlicht, insbesondere Weißlicht zu erzeugen.

Das LED Trägermodul kann dabei eine Vielzahl von gleichartigen oder unterschiedlichen LED Chips aufweisen, welche ein vorzugsweise weißes Mischlicht erzeugen.

Das Substrat des Trägermoduls und die Leiterplatte sind vorzugsweise aus unterschiedlichen Materialien hergestellt. Die Leiterplatte besteht vorzugsweise aus FR4 Material. Das Substrat des LED Trägermoduls ist vorzugsweise aus IMS ("Insulated Metal Substrate") Material. Das IMS Material ermöglicht dabei ein optimiertes Wärmemanagement, insbesondere bei Hochleistungs-LEDs. Das Substrat kann eine Aluminiumkernleiterplatte sein.

Die Erfindung bezieht sich zudem auf ein Verfahren zur Ansteuerung eines LED Chips auf einem Trägermodul, umfassend die Schritte
- Verbinden eines LED Trägermoduls aufweisend wenigstens einen LED Chip mit einer Leiterplatte eines LED Moduls, und
- Ansteuerung des wenigstens einen LED Chips des LED Trägermoduls mit einer auf der Leiterplatte angeordneten integrierten Konverter-Elektronik, welche eingangsseitig mit Netzspannung versorgt wird.

In Übereinstimmung mit den obigen Ausführungen erfolgt die Ansteuerung des LED Trägermoduls vorzugsweise in Abhängigkeit von Informationen, welche von einem Sensor auf dem LED Trägermodul der integrierten Konverter-Elektronik der Leiterplatte bereitgestellt werden.

Die vorliegende Erfindung wird nun noch detaillierter mit Bezug auf die beigefügten Zeichnungen beschrieben.
- Fig. 1a: zeigt eine Explosionsansicht eines bevorzugten Ausführungsbeispiels des erfindungsgemäßen LED Moduls
- Fig. 1b: zeigt eine Draufsicht des LED Moduls gemäß Figur 1a.
- Fig. 1c: zeigt das LED Modul gemäß Figuren 1a und 1b in Schnittansicht.
- Fig. 2a: zeigt eine Explosionsansicht einer vorteilhaften Weiterbildung des Ausführungsbeispiels gemäß Figuren 1a bis 1c.
- Fig. 2b: zeigt eine Draufsicht des LED Moduls gemäß Figur 2a.
- Fig. 2c: zeigt das LED Modul gemäß Figuren 2a und 2b in Schnittansicht.
- Fig. 3a: zeigt ein weiteres Ausführungsbeispiel des erfindungsgemäßen LED Moduls ohne Zwischenträger.
- Fig. 3b: zeigt eine Draufsicht des LED Moduls gemäß Fig. 3a.
- Fig. 4a: zeigt ein weiteres Ausführungsbeispiel des erfindungsgemäßen LED Moduls, wobei die Leiterplatte eine Aussparung für das LED Trägermodul aufweist.
- Fig. 4b: zeigt eine Draufsicht des LED Moduls gemäß Fig. 4a.
- Fig. 5a: zeigt eine Explosionsansicht eines bevorzugten Ausführungsbeispiels des erfindungsgemäßen LED Trägermoduls.
- Fig. 5b: zeigt eine Draufsicht des LED Trägermoduls gemäß Figur 5a.
- Fig. 5c: zeigt eine Schnittansicht des Trägermoduls gemäß Figur 5a und 5b.
- Fig. 6: zeigt eine Schnittansicht eines erfindungsgemäßen Trägermoduls, aufweisend einen Sensor.
- Fig. 7: zeigt eine Draufsicht auf ein weiteres Ausführungsbeispiel des Trägermoduls.

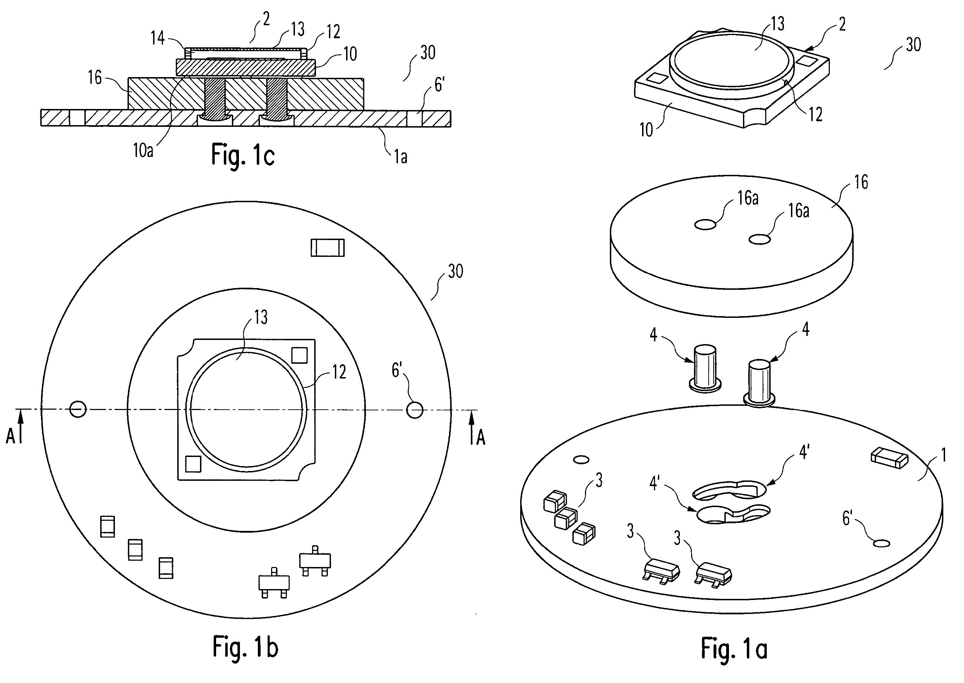

In Figur 1a bis 1c ist ein erstes bevorzugtes Ausführungsbeispiel für ein erfindungsgemäßes LED Modul 30 dargestellt. Das LED Modul 30 weist eine Leiterplatte 1 auf, auf welcher die Konverter-Elektronik angebracht ist. Die Konverter-Elektronik 3 umfasst vorzugsweise ein Wandlermodul und/oder ein Gleichrichtermodul. Die Konverter-Elektronik weist zudem vorzugsweise einen Anschluss für Netzspannung auf (nicht dargestellt).

Die Leiterplatte 1 kann eine kreisrunde oder rechteckige Form aufweisen. Die Oberfläche 1b der Leiterplatte ist vorzugsweise planar. Die Oberfläche 1b kann reflektierend ausgeführt sein. Das Material aus dem die Leiterplatte 1 hergestellt ist kann selbst reflektierend sein (z.B. Metall, Keramik), oder eine reflektierende Schicht aufweisen, welche auf die Oberfläche der Leiterplatte 1 aufgebracht ist.

Auf der Rückseite 1a der Leiterplatte kann ein Kühlmittel (nicht gezeigt) angebracht sein. Die Rückseite der Leiterplatte 1a kann zudem Verbindungsmittel aufweisen, um die Leiterplatte mit einer Lampe oder Montagefläche zu verbinden.

Die Leiterplatte 1 weist vorzugsweise integrale Verbindungsmittel 4` auf, welche eine mechanische Verbindung der Leiterplatte 1 mit einem LED Trägermodul 2 ermöglichen. Die Verbindungsmittel 4' können wie dargestellt spezifisch geformte Ausnehmungen in der Leiterplatte und/oder Löcher sein, welche mit entsprechenden Verbindungsmitteln 4 des LED Trägermoduls 2 selektiv verbindbar sind. Die Verbindungsmittel 4 des Trägermoduls können dabei Stifte oder Zapfen 4 sein, welche in die Ausnehmungen 4` der Leiterplatte eingreifen und mit diesem vorzugsweise durch Drehung verriegelbar sind. Insbesondere kann ein Bajonette-Verschluss 4,4` realisiert sein, welcher eine selektive Verbindung zwischen LED Trägermodul 2 und Leiterplatte 1 ermöglicht. Die Stifte oder Zapfen 4 können dabei integral mit einem Substrat 10 des Trägermoduls 2 geformt sein oder mit diesem selektiv verbindbar sein. Des Weiteren können die Stifte oder Zapfen 4 mit Hilfe eines Stoffschlussverfahrens wie zum Beispiel Kleben oder Löten an das Trägermodul 2 angebracht sein.

Zwischen Trägermodul 2 und Leiterplatte 1 kann ein Kühlkörper 16 angeordnet sein. Dieser kann eine flache vorzugsweise runde Form aufweisen. Der Kühlkörper weist vorzugsweise Verbindungsmittel 16a, wie beispielsweise Bohrungen auf, durch welche die Verbindungsstifte oder - zapfen 4 gesteckt werden können. Die Verbindungsmittel 4,4' zwischen Leiterplatte 1 und Trägermodul 2 sind daher ausgeprägt ein Positionieren und Halten des Kühlkörpers zu ermöglichen.

Die Oberfläche der Oberseite 10c des Substrats 10 kann reflektierend ausgeführt sein. Das Material aus dem das Substrat 10 hergestellt ist kann selbst reflektierend sein (z.B. Metall, Keramik), oder eine reflektierende Schicht aufweisen, welche auf die Oberfläche des Substrats 10 aufgebracht werden.

Der Kühlkörper 16 dient vorzugsweise als Wärmesenke zur Wärmeabfuhr von dem LED Trägermodul 2. Der Kühlkörper bzw. die Wärmesenke ist vorzugsweise aus einem gut wärmeleitenden Material, z.B. Metall (Aluminium), Keramik oder aus einem gut wärmeleitenden Kunststoff gefertigt. Die Oberfläche des Kühlkörpers ist vorzugsweise hochreflektierend ausgebildet.

Figur 1c zeigt das LED Trägermodul 2 und die Leiterplatte 1 in deren verbundenen Zustand. Dabei sind die Verbindungszapfen 4 in den vorgesehenen Ausnehmungen 4' des Bajonette-Verschlusses des LED Moduls durch Drehen eingerastet. Die Verbindungszapfen 4 können beispielsweise durch Presspassung oder Verkleben an der Rückseite 10a des LED Trägermoduls 10 angebracht sein.

Es können auch elektrische Kontakte in den Verbindungszapfen 4 vorgesehen sein, welche eine elektrische Verbindung zwischen dem LED Trägermodul 2 und der Leiterplatte 1 im Verbundenen Zustand ermöglichen.

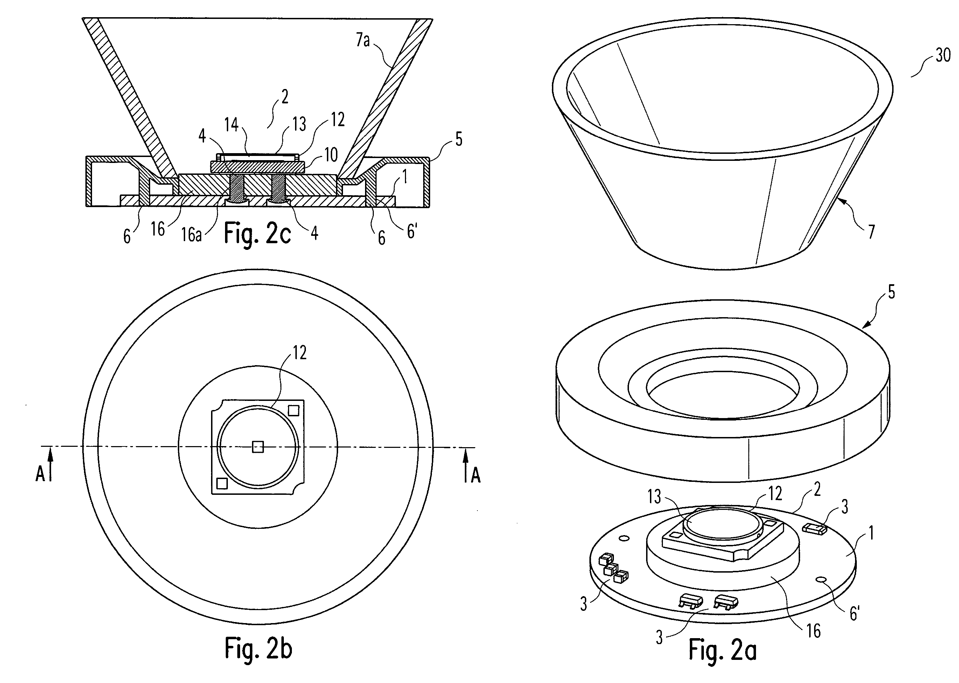

In Figuren 2a bis 2c ist gezeigt, dass das erfindungsgemäße LED Modul 30 vorteilhafterweise ein Gehäuse 5 aufweist, welches selektiv mit der Leiterplatte 1 verbindbar ist. Dies geschieht vorzugsweise mit mechanischen Verbindungsmitteln 6, 6', welche an Gehäuse 5 und Leiterplatte 1 vorgesehen sind. Im gezeigten Beispiel weist die Leiterplatte 1 Ausnehmungen bzw. Bohrungen 6' auf, in welche Reibzapfen 6 des Gehäuses eingepresst werden können (siehe zusammengesetzter Zustand der Leiterplatte 1 und des Trägermoduls in Figur 2c).

Das LED Modul 30 weist zudem vorzugsweise einen Reflektor 7 auf, welcher mittels vorgesehener Verbindungsmittel (nicht gezeigt) an dem Gehäuse 5 und/oder an der Leiterplatte 1 selektiv befestigbar ist. Figuren 2b und 2c zeigen das LED Modul 30 mit aufgesetztem bzw. verbundenen Reflektor 7.

Der Reflektor 7 ist vorzugsweise aus Metall oder beschichtetem Plastik. Eine innere Fläche 7a des Reflektors kann hochreflektierend ausgebildet sein. Der Reflektor hat vorzugsweise eine im Wesentlichen trichterförmige Form. In einem anderen Ausführungsbeispiel kann der Reflektor 7 parabolisch geformt sein.

Im verbundenen Zustand wie in Figur 2c gezeigt deckt das Gehäuse 5 die Oberfläche der Leiterplatte 1 komplett ab. Insbesondere die Konverter-Elektronik 3 kann demzufolge von Umwelteinflüssen geschützt werden. Das Gehäuse 5 kann zusätzlich Dichtungen gegen Staub und/oder Flüssigkeit aufweisen, welche im verbundenen Zustand des LED Moduls 30 einen Eintritt von Staub und/oder Flüssigkeit vermeiden.

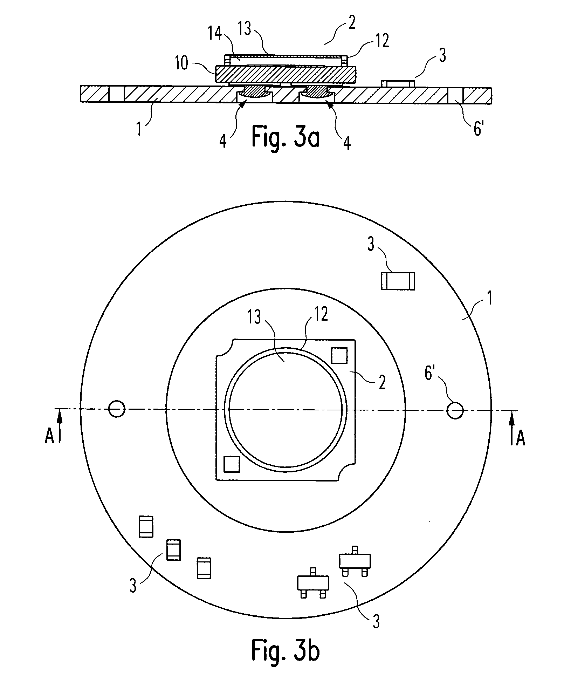

Figur 3a zeigt ein weiteres Ausbildungsbeispiel der Erfindung, gemäß welchem das LED Trägermodul 2 ohne Zwischenträger oder Kühlkörper direkt auf der Oberfläche 1b der Leiterplatte 1 angebracht ist.

Hierbei können die zuvor beschriebenen mechanischen Verbindungsmittel 4 vorgesehen sein, welche mit Aussparungen 4' der Leiterplatte 1 selektiv verbindbar sind.

Wie bereits beschrieben kann eine elektrische Kontaktierung des LED Trägermoduls 2 mit der Leiterplatte 1 mit Hilfe der Verbindungsmittel 4 erfolgen.

Alternativ oder zusätzlich kann die Rückseite 10a elektrische Kontakte aufweisen, welche derart positioniert sind, dass diese im verbundenen Zustand (siehe Figur 3a) des LED Trägermoduls 2 und der Leiterplatte 1 mit entsprechenden Kontakten auf der Leiterplatte 1 in Eingriff stehen oder sich kontaktieren, derart, dass eine elektrische Verbindung zwischen Trägermodul 2 und Leiterplatte 1 ermöglicht wird.

Die elektrischen Kontakte des Trägermoduls 2 und der Leiterplatte 1 können beispielsweise mittels Dickschichttechnologie aufgedruckte Leitungen oder Kontakte sein.

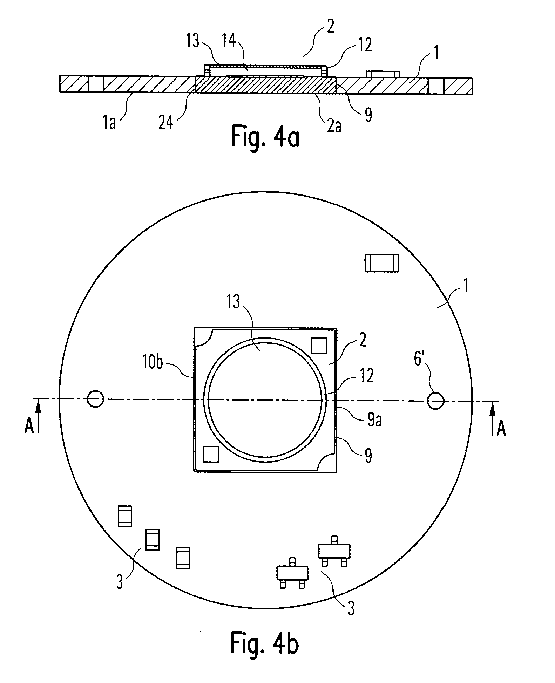

Figur 4a und 4b zeigen ein weiteres Ausführungsbeispiel gemäß welchem die Leiterplatte 1 eine Aussparung 9 aufweist, in welche das LED Trägermodul 2 selektiv einsetzbar ist. Hierzu ist die Umfangfläche 10b eines Substrats 10 des Trägermoduls vorzugsweise konform mit der Innenfläche 9a der Aussparung 9 ausgeprägt. An der Umfangsfläche 10b des Trägermoduls 2 und/oder an der Innenfläche 9a der Aussparung 9 sind vorzugsweise mechanische Verbindungsmittel 24 vorgesehen, welche eine selektive Verbindung dieser Bauteile ermöglichen.

Die Rückseite des Trägermoduls 2a bzw. die Rückseite des Substrats 10a des Trägermoduls ist im verbundenen Zustand vorzugsweise bündig mit einer Rückseite 1a der Leiterplatte 1 angeordnet. Ein Kühlkörper (nicht gezeigt) kann vorgesehen sein, welcher an der Rückseite 1a angeordnet ist. Dieser liegt im eingesetzten bzw. verbundenen Zustand des Trägermoduls 2 auch an dessen Rückseite 2a vollflächig an und ermöglicht somit eine effektive Wärmeabfuhr.

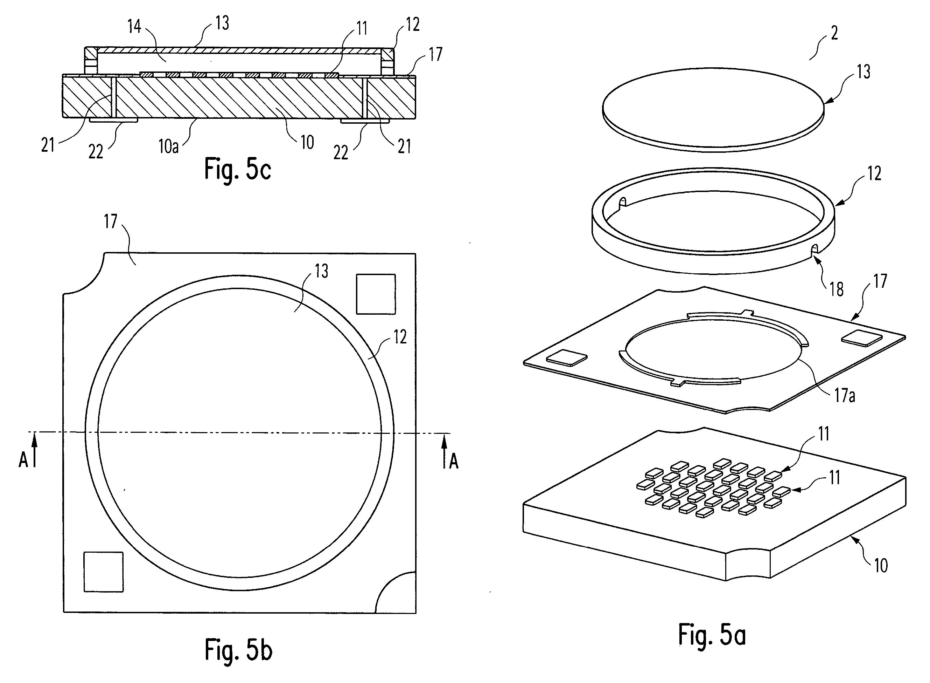

Figur 5a bis 5c zeigen Detailansichten des erfindungsgemäßen LED Trägermoduls 2. Das LED Trägermodul 2 weist ein Substrat 10 auf, welches vorzugsweise aus IMS Material besteht. Auf dem Substrat 10 ist wenigstens ein LED Chip 11 angeordnet. Wie in Figur 5a gezeigt ist, kann auch eine Vielzahl von LED Chips 11 auf dem Substrat angeordnet sein. Die LED Chips 11 sind dabei mit Leiterbahnen oder Kontakten auf der Oberfläche des Substrats elektrisch verbunden. Die LED Chips 11 können in "face up" oder "face down" Anordnung auf dem Substrat montiert sein.

Die Oberfläche 10c des Substrats 10 kann vorzugsweise reflektierend ausgeführt sein. Das Substrat 10 kann eine Metallplatte sein oder eine reflektierende Schicht auf ihrer Oberfläche umfassen.

Es kann auch ein "Printed Circuit Board" (PCB) 17 vorgesehen sein mit welchem die LED Chips 11 kontaktiert sind. Das PCB weist dabei vorzugsweise eine zentrale Ausnehmung 17a auf, durch welche die LED Chips im zusammengesetzten Zustand des LED Trägermoduls 2 ragen. Die LED Chips 11 können mit den elektrischen Kontakten des PCB beispielsweise mit Hilfe von Bonddrähten verbunden sein.

Das LED Trägermodul 2 umfasst ein Distanzelement 12, welches vorzugsweise aus Keramik gefertigt ist. Das Distanzelement kann bspw. aus Metall gefertigt werden. Das Distanzelement 12 stellt somit einen Keramikring dar, welcher die LED Chips 11 umgibt. Der Keramikring 12 ermöglicht das Füllen eines Innenraums des Rings 12 mit Vergussmasse 14. Der Keramikring 12 kann dabei seitliche Öffnungen 18 aufweisen, mit Hilfe derer eine Vergussmasse 14 in den vom Keramikring 12 und einer optionalen Scheibe 13 begrenzten Innenraum des Trägermoduls eingefüllt werden kann. Die Scheibe 13 kann eine Glas oder Plastikscheibe sein, welche mit dem Keramikring 12 fest verbindbar ist.

Die Scheibe 13 kann als Streuscheibe und/oder als Leuchtstoffscheibe ausgeführt sein. Die Scheibe 13 kann Leuchtpartikel und/oder Streupartikel aufweisen. Die Scheibe 13 kann eine Beschichtung mit Leuchtstoffpartikel und/oder Streupartikel aufweisen.

Das Trägermodul 2 kann elektrische Durchkontaktierungen 21 aufweisen, welche Leiterbahnen oder elektrische Kontakte 22 auf der Rückseite 10a des Substrats 10 mit den LED Chips 11 und/oder dem PCB 17 elektrisch verbinden.

Die Vergussmasse 14 weist vorzugsweise Phosphorpartikel auf, welche eine Farbkonversion des von den LED Chips 11 abgegebene Lichts wenigstens teilweise ermöglichen.

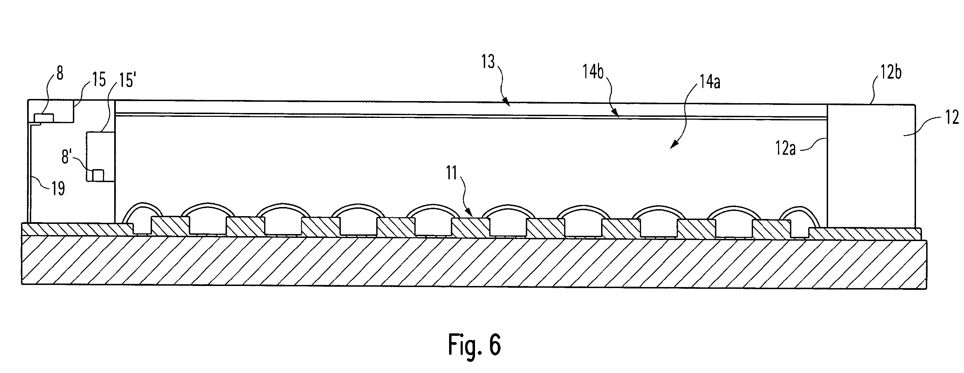

Wie in Figur 6 gezeigt, kann die Vergussmasse 14 eine erste untere Schicht 14a aufweisen, welche Streupartikel und/oder andere Partikel enthält, welche die thermischen Eigenschaften der Vergussmasse verbessern. Die Vergussmassse kann in dieser ersten Schicht 14a oder in einer darüber angebrachten Schicht 14b Phosphorpartikel enthalten, welche ein Farbkonversion des von den LED Chips 11 emittierten Lichts ermöglicht. Diese zweite Schicht 14b ist vorzugsweise direkt an die Scheibe 13 angrenzend geformt.

Das LED Trägermodul 2 kann wenigstens einen Sensor 8 aufweisen, welcher vorzugsweise im verbundenen Zustand des LED Trägermoduls 2 mit der Leiterplatte 1 kommunizieren kann.

Der Sensor 8 ist vorzugsweise in einer vorgesehenen Aussparung 15 angeordnet, damit das Licht der LED Chips 11 nicht direkt auf den Sensor 8 trifft. Die Aussparung 15 kann in einer Stirnseite des Keramikrings 12 angeordnet sein.

Alternativ kann eine Kante oder ein Vorsprung auch in der Innenfläche 12a des Rings 12 vorgesehen sein, hinter welcher bzw. in welchem der Sensor 8' angeordnet ist.

Das Distanzelement bzw. der Keramikring 12 weist vorzugsweise elektrische (Durch-)Kontaktierungen und/oder Leiterbahnen 19 auf, um den Sensor 8,8' mit dem PCB 17 und/oder Kontakten auf dem Substrat 10 des LED Trägermoduls 2 elektrisch zu verbinden. Diese sind wiederum vorzugsweise im verbundenen Zustand des LED Trägermoduls 2 mit der Leiterplatte 1 elektrisch verbunden, so dass eine Verbindung drahtgebundenen Verbindung zwischen Sensor 8,8' und der Konverter-Elektronik der Leiterplatte 1 herstellbar ist.

Alternativ kann eine drahtlose Kommunikation zwischen dem Sensor 8,8' und der Konverter-Elektronik 3 der Leiterplatte 1 vorgesehen sein.

Es besteht vorzugsweise eine Datenkommunikation zwischen der LED Konverter-Elektronik 3 der Leiterplatte 1 und dem Sensor 8,8'. Beispielsweise kann der Sensor ein Tageslichtsensor sein, so dass kann die Konverter-Elektronik die Ansteuerung des LED Trägermoduls 2 hinsichtlich der Lichtstärke und/oder Farbe abhängig von Erfassung durch den Lichtsensor durchführt.

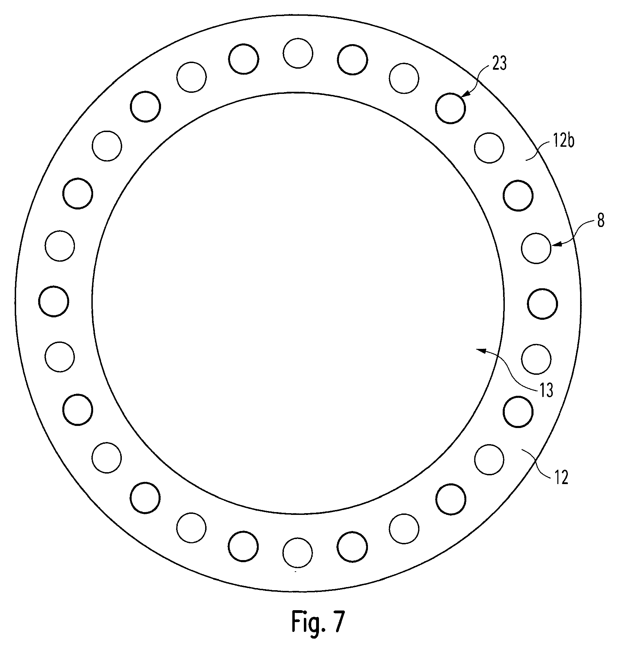

Wie in Figur 7 gezeigt, kann das Distanzelement 12 Infrarotlichtquellen 23 aufweisen, welche vorzugsweise an der Stirnfläche des Rings 12 angeordnet sind. Ebenfalls auf der Stirnfläche 12 sind Bewegungssensoren 8 angeordnet.

Sobald einer der Bewegungssensoren 8 ausgelöst wird, kann die Lichtquelle mit Hilfe der vom Bewegungssensor 8 an die Konverter-Elektronik 3 übertragenen Information aktiviert und somit die LED Chips 11 mit Strom versorgt werden.

Es kann damit beispielsweise ein Bewegungsmelder auf Infrarotbasis realisiert werden.

## Patentansprüche

1. LED Modul, mit modularem Aufbau das direkt in einer Lampe verbaut werden kann, aufweisend:
a) eine Leiterplatte (1) und ein LED Trägermodul (2), die als Komponenten des LED Moduls einfach selektiv miteinander verbindbar sind, wobei
b) die Leiterplatte (1) eine integrierte Konverter-Elektronik (3) für das LED Trägermodul (2) aufweist, welche eingangsseitig der Konverter-Elektronik (3) einen Anschluss der Leiterplatte an Netzspannung ermöglicht, wobei
c) das LED Trägermodul (2) wenigstens einen auf einem Substrat (10) angeordneten LED Chip (11) aufweist,
wobei
d) das Trägermodul (2) mechanische Verbindungsmittel (4) aufweist, über die es selektiv mit der Leiterplatte (1) über an dieser entsprechend ausgebildete Verbindungsmittel (4') verbindbar ist, wobei
e) das LED Trägermodul (2) wenigstens einen Sensor (8,8') aufweist, welcher ausgeprägt ist, mit der Konverter-Elektronik (3) der Leiterplatte (1) zu kommunizieren, und wobei
f) das LED Modul ferner ein Gehäuse (5) umfasst, welches selektiv mit der Leiterplatte (1) durch vorgesehene mechanische Verbindungsmittel (6,6') verbindbar ist, derart, dass die Konverter-Elektronik (3) der Leiterplatte (1) von Umwelteinflüssen geschützt ist.

2. LED Modul nach Anspruch 1, wobei das LED Modul ferner einen Reflektor (7) umfasst, welcher selektiv mit der Leiterplatte (1) und/oder einem an der Leiterplatte befestigten Gehäuse (5) durch vorgesehene mechanische Verbindungsmittel verbindbar ist.

3. LED Modul nach einem der vorhergehenden Ansprüche, wobei die mechanischen Verbindungsmittel (4,4`,6,6`) einen Bajonette-Verschluss, Schrauben und/oder Reibzapfen umfassen.

4. LED Modul nach einem der vorhergehenden Ansprüche, wobei die Leiterplatte (1) eine Ausnehmung (9) aufweist, in welche das LED Trägermodul (2) selektiv einsetzbar ist, derart, dass eine Rückseite (2a) des LED Trägermoduls vorzugsweise bündig mit einer Rückseite (1a) der Leiterplatte (1) angeordnet ist.

5. LED Modul nach einem der vorhergehenden Ansprüche, wobei die Konverter-Elektronik (3) der Leiterplatte (1) derart ausgeprägt ist, um eine Ansteuerung des wenigstens einen LED Chips (11) des mit der Leiterplatte (1) verbundenen LED Trägermoduls (2) in Abhängigkeit von Informationen zu ermöglichen, welche von dem Sensor (8,8`) des LED Trägermoduls (1) bereitgestellt werden.

6. LED Modul nach einem der vorhergehenden Ansprüche, wobei. die Kommunikation zwischen dem Sensor (8,8`) des LED Trägermoduls (2) und der Konverter-Elektronik (3) der Leiterplatte (1) eine drahtlose oder drahtgebundene Datenkommunikation ist.

7. LED Modul nach einem der vorhergehenden Ansprüche, wobei der Sensor (8,8`) einen Tageslichtsensor umfasst, und die Konverter-Elektronik (3) ausgeprägt ist, die Ansteuerung des LED Trägermoduls (2) hinsichtlich der Lichtstärke und/oder Farbe in Abhängigkeit von der vom Tageslichtsensor bereitgestellten Information durchzuführen.

8. LED Modul nach einem der vorhergehenden Ansprüche, wobei das LED Trägermodul (2) ein vorgefertigtes Distanzbauteil (12), vorzugsweise einen Keramikring, aufweist, welches den wenigstens einen LED Chip (11) umgibt.

9. LED Modul nach Anspruch 8, wobei das Distanzbauteil (12) des LED Trägermoduls (2) mit einer Glas- oder Plastikscheibe (13) abgedeckt ist und/oder wenigstens teilweise mit Vergussmasse (14,14a,14b) ausgefüllt ist.

10. LED Modul nach einem der vorhergehenden Ansprüche, wobei der wenigstens eine Sensor (8,8`) in einem Distanzbauteil (12), vorzugsweise einem Keramikring, des LED Trägermoduls (2) derart angeordnet ist, dass das von dem wenigstens einen LED Chip (11) des Trägermoduls (2) emittierte Licht nicht direkt auf den Sensor (8,8`) fällt.

11. LED Modul nach Anspruch 10, wobei das Distanzbauteil (12) wenigstens einen Vorsprung und/oder eine Kante (15,15`) aufweist, welche eine direkte Beaufschlagung des Sensors (8,8') , durch das von dem LED Chip emittierte Licht verhindert.

12. LED Modul nach einem der vorhergehenden Ansprüche, wobei das Substrat (10) des LED Trägermoduls (2) und die Leiterplatte (1) aus unterschiedlichen Materialien bestehen.

13. LED Modul nach Anspruch 12, wobei das Substrat (10) aus IMS Material und/oder die Leiterplatte (1) aus FR4 Material gebildet ist.

14. LED Modul nach einem der vorhergehenden Ansprüche, wobei die Oberfläche des Substrats (10) und/oder der Leiterplatte (1) hochreflektierend ausgeführt sind.

15. LED Modul nach einem der vorhergehenden Ansprüche, wobei das LED Modul einen Kühlkörper (16) aufweist, welcher zwischen der Leiterplatte (1) und dem LED Trägermodul (2) angebracht ist.

16. LED Modul nach Anspruch 15, wobei der Kühlkörper (16) Metall, Kunststoff und/oder Keramik umfasst.

17. LED Modul nach Anspruch 15 oder 16, wobei die Wärmeleitfähigkeit des Kühlkörpers (16) zwischen 10 und 400 W/mK, bevorzugt zwischen 50 und 400 W/mK ist.

18. LED Module nach einem der Ansprüche 15 bis 17, wobei die Oberfläche des Kühlkörpers (16) hochreflektierend ausgeführt ist.

19. Verfahren zur Ansteuerung eines LED Chips (11) auf einem LED Trägermodul (2) das mit einer Leiterplatte (1) ein LED Modul mit modularem Aufbau entsprechend einem oder mehreren der vorhergehenden Ansprüche 1 - 18 bildet, aufweisend die Schritte Verbinden des LED Trägermoduls (2) aufweisend wenigstens einen LED Chip (11) mit der Leiterplatte (1) mittels einer lösbaren mechanischen Verbindung (4,4'), und - Ansteuerung des wenigstens einen LED Chips (11) des LED Trägermoduls (2) mit einer auf der Leiterplatte (1) angeordneten integrierten Konverter-Elektronik (3), welche eingangsseitig mit Netzspannung versorgt wird, wobei die Ansteuerung des LED Trägermoduls (2) in Abhängigkeit von Informationen erfolgt, welche von einem Sensor (8,8') auf dem LED Trägermodul (2) der integrierten Konverter-Elektronik (3) der Leiterplatte (1) bereitgestellt werden.

## Claims

1. LED module, with modular design that may be installed directly into a lamp, comprising:
a) a circuit board (1) and an LED carrier module (2), which are simply selectively connected to one another as components of the LED module, wherein
b) the printed circuit board (1) comprises an integrated converter electronics (3) for the LED carrier module (2), which may be connected at the input side of the converter electronics (3) to allow connection of the circuit board to a mains voltage, wherein
c) the LED carrier module (2) has at least one LED chip (11) arranged on a substrate (10), wherein
d) the carrier module (2) comprises mechanical connection means (4) via which it may be selectively connected to the circuit board (1) via a correspondingly formed connecting means (4'), wherein
e) the LED carrier module (2) comprises at least one sensor (8, 8'), which is designed to communicate with the converter electronics (3) of the printed circuit board (1), and wherein
f) the LED module further comprises a housing (5) which may be selectively connected to the printed circuit board (1) through provided mechanical connection means (6, 6'), so that the converter electronics (3) of the printed circuit board (1) is protected against environmental influences.

2. LED module according to claim 1,
wherein the LED module further comprises a reflector (7), which may be selectively connected to the printed circuit board (1) and/or to a housing (5) attached to the circuit board through provided mechanical connection means.

3. LED module according to one of the preceding claims,
wherein the mechanical connecting means (4, 4', 6, 6') comprise a bayonet connector, screws and/or studs.

4. LED module according to one of the preceding claims
wherein the printed circuit board (1) comprises a recess (9) in which the LED carrier module (2) may be selectively inserted so that a rear face (2a) of the LED support module is preferably arranged flush with a rear surface (1 a) of the circuit board (1).

5. LED module according to one of the preceding claims,
wherein the converter electronics (3) of the printed circuit board (1) is designed to control the at least one LED chip (11) of the LED carrier module (2) connected to the printed circuit board (1) as a function of information which is provided from the sensor (8, 8') of the LED carrier module (1).

6. LED module according to one of the preceding claims,
wherein the communication between the sensor (8, 8') of the LED support module (2) and the converter electronics (3) of the printed circuit board (1), is wireless or wired data communication.

7. LED module according to one of the preceding claims,
wherein the sensor (8, 8') comprises a daylight sensor, and the converter electronics (3) controls the LED carrier module (2) with respect to the luminous intensity and/or color as a function of the information provided by the daylight sensor.

8. LED module according to one of the preceding claims,
wherein the LED module carrier (2) comprises a prefabricated spacer component (12), preferably a ceramic ring, which surrounds the at least one LED chip (11).

9. LED module according to claim 8,
wherein the spacer component (12) of the LED carrier module (2) is covered with a glass or plastic disc (13) and/or at least partially filled with casting compound (14, 14a, 14b).

10. LED module according to one of the preceding claims,
wherein the at least one sensor (8, 8') is so arranged in a spacer component (12), preferably a ceramic ring, of the LED carrier module (2) that the light emitted from the at least one LED chip (11) of the carrier module (2) does not fall directly onto the sensor (8, 8').

11. LED module according to claim 10,
wherein the spacer component (12) comprises at least one projection and/or edge (15, 15') which prevents direct impingement of the light emitted from the LED chip on the sensor (8, 8').

12. LED module according to one of the preceding claims,
wherein the substrate (10) of the LED carrier module (2) and the printed circuit board (1) are made of different materials.

13. LED module according to claim 12,
wherein the substrate (10) is made of IMS material and/or the printed circuit board (1) is made of FR4 material.

14. LED module according to one of the preceding claims,
wherein the surface of the substrate (10) and/or the printed circuit board (1) is/are made to be highly reflective.

15. LED module according to one of the preceding claims,
wherein the LED module comprises a heat sink (16) positioned between the printed circuit board (1) and the LED module carrier (2).

16. LED module according to claim 15,
wherein the heat sink (16) is made of metal, plastic and/or ceramic.

17. LED module according to claim 15 or 16,
wherein the thermal conductivity of the heat sink (16) lies between 10 and 400 W/mK, preferably between 50 and 400 W/mK.

18. LED module according to any one of the claims 15 to 17,
wherein the surface of the heat sink (16) is made to be highly reflective.

19. Method for controlling an LED chip (11) on an LED carrier module (2) that, together with a printed circuit board (1), forms an LED module with a modular structure according to one or more of the preceding claims 1 - 18, comprising the steps: connection of one of the LED carrier modules (2) comprising at least one LED chip (11) to one of the printed circuit boards (1) by means of a detachable mechanical connection (4, 4'), and control of the at least one LED chip (11) of the LED carrier module (2) with integrated converter electronics (3) arranged on the printed circuit board (1), which is supplied with mains voltage on the input side, wherein the control of the LED carrier module (2) is effected as a function of the information that is provided by a sensor (8, 8') on the LED carrier module (2) to the integrated converter electronics (3) of the printed circuit board (1).

## Revendications

1. Module à LED avec une structure modulaire qui peut être montée directement dans une lampe, comprenant :
a) un circuit imprimé (1) et un module de support de LED (2), qui peuvent être reliés entre eux en tant que composants du module à LED de manière simplement sélective,
b) le circuit imprimé (1) comprenant une électronique de convertisseur intégrée (3) pour le module de support de LED (2), qui permet, du côté de l'entrée de l'électronique du convertisseur (3), un branchement du circuit imprimé à la tension du secteur,
c) le module de support de LED (2) comprenant au moins une puce à LED (11) disposée sur un substrat (10),
d) le module de support (2) comprend des moyens de liaison mécaniques (4), par l'intermédiaire desquels il peut être relié de manière sélective avec le circuit imprimé (1) par l'intermédiaire de moyens de liaison (4') conçus de manière correspondante à ceux-ci,
e) le module de support (2) comprenant au moins un capteur (8, 8') qui est conçu pour communiquer avec l'électronique de convertisseur (3) du circuit imprimé (1) et
f) le module à LED comprenant en outre un boîtier (5) qui peut être relié de manière sélective avec le circuit imprimé (1) à l'aide de moyens de liaison mécaniques (6, 6') de façon à ce que l'électronique de convertisseur (3) du circuit imprimé (1) soit protégée des influences extérieures.

2. Module à LED selon la revendication 1, le module à LED comprenant en outre un réflecteur (7), qui peut être relié de manière sélective avec le circuit imprimé (1) et/ou avec un boîtier (5) fixé au circuit imprimé par l'intermédiaire de moyens de liaison mécaniques.

3. Module à LED selon l'une des revendications précédentes, les moyens de liaison mécaniques (4, 4', 6, 6') comprenant une fermeture à baïonnette, des vis et/ou des tenons.

4. Module à LED selon l'une des revendications précédentes, le circuit imprimé (1) comprenant un évidement (9) dans lequel le module de support de LED (2) peut être inséré de manière sélective de façon à ce qu'un côté arrière (2a) du module de support de LED soit disposé de préférence en affleurement par rapport à un côté arrière (1a) du circuit imprimé (1).

5. Module à LED selon l'une des revendications précédentes, l'électronique de convertisseur (3) du circuit imprimé (1) étant conçue de façon à ce que, pour permettre un contrôle de l'au moins une puce à LED (11) du module de support de LED (2) relié au circuit imprimé (1) en fonction d'informations qui sont fournies par le capteur (8, 8') du module de support de LED (1).

6. Module à LED selon l'une des revendications précédentes, la communication entre le capteur (8, 8') du module de support de LED (2) et l'électronique de convertisseur (3) du circuit imprimé (1) est une communication de données sans fil ou filaire.

7. Module à LED selon l'une des revendications précédentes, le capteur (8, 8') comprenant un capteur de lumière du jour et l'électronique de convertisseur (3) étant conçue pour effectuer un contrôle du module de support de LED (2) en ce qui concerne l'intensité lumineuse et/ou la couleur en fonction des informations fournies par le capteur de lumière du jour.

8. Module à LED selon l'une des revendications précédentes, le module de support de LED (2) comprenant un composant d'écartement (12), de préférence une bague en céramique, qui entoure l'au moins une puce à LED (11).

9. Module à LED selon la revendication 8, le composant d'écartement (12) du module de support de LED (2) étant recouvert d'un disque de verre ou de matière plastique (13) et/ou au moins partiellement rempli d'une masse de scellement (14, 14a, 14b).

10. Module à LED selon l'une des revendications précédentes, l'au moins un capteur (8, 8') étant disposé dans un composant d'écartement (12), de préférence une bague en céramique, du module de support de LED (2) de façon à ce que la lumière émise par l'au moins une puce à LED (11) du module de support (2) ne tombe pas directement sur le capteur (8, 8').

11. Module à LED selon la revendication 10, le composant d'écartement comprenant une saillie et/ou une arête (15, 15') qui empêche un éclairage direct du capteur (8, 8') par la lumière émise par la puce à LED.

12. Module à LED selon l'une des revendications précédentes, le substrat (10) du module de support de LED (2) et le circuit imprimé (1) étant constitués de différents matériaux.

13. Module à LED selon la revendication 12, le substrat (10) étant constitué de matériau IMS et/ou le circuit imprimé (1) étant constitué de matériau FR4.

14. Module à LED selon l'une des revendications précédentes, la surface du substrat (10) et/ou du circuit imprimé (1) sont conçues de manière hautement réfléchissante.

15. Module à LED selon l'une des revendications précédentes, le module à LED comprenant un corps de refroidissement (16) qui est monté entre le circuit imprimé (1) et le module de support de LED (2).

16. Module à LED selon la revendication 15, le corps de refroidissement (16) comprenant du métal, une matière plastique et/ou de la céramique.

17. Module à LED selon la revendication 15 ou 16, le conductivité thermique du corps de refroidissement (16) est de 10 à 400 W/mK, de préférence de 50 à 400 W/mK.

18. Module à LED selon l'une des revendications 15 à 17, la surface du corps de refroidissement (16) étant conçue de manière hautement réfléchissante.

19. Procédé de contrôle d'une puce à LED (11) sur un module de support de LED (2) qui constitue, avec un circuit imprimé (1), un module à LED avec une structure modulaire selon l'une ou plusieurs des revendications précédentes 1 à 18, comprenant les étapes suivantes : liaison du module de support de LED (2), comprenant au moins une puce à LED (11), avec le circuit imprimé (1) au moyen d'une liaison mécanique amovible (4, 4') et contrôle de l'au moins une puce à LED (11) du module de support de LED (2) avec une électronique de convertisseur intégrée (3), disposée sur le circuit imprimé (1), qui est alimentée du côté de l'entrée avec la tension du secteur, le contrôle du module de support de LED (2) ayant lieu en fonction d'informations qui sont fournies par un capteur (8, 8') sur le module de support de LED (2) de, l'électronique de convertisseur intégrée (3) du circuit imprimé (1).
